# EUROPÄISCHE PATENTSCHRIFT

(11) **EP 0 926 941 B1**
(45) Veröffentlichungstag und Bekanntmachung des Hinweises auf die Patenterteilung: **26.05.2004**
(21) Anmeldenummer: 98440255.2
(22) Anmeldetag: 13.11.1998
(51) Int. Cl.: H05K 9/00, H05K 5/02

(54) **Gehäuse mit EMV-geschirmter Kabeldurchführung**
Housing with EMI-shielded cable feed-through
Boîtier avec traversée de câble blindé

(30) Priorität: 20.12.1997 DE 19757041
(43) Veröffentlichungstag der Anmeldung: 30.06.1999
(73) Patentinhaber: ALCATEL, 75008 Paris (FR)
(72) Erfinder: Steffen, Guenter, 71282 Hemmingen (DE); Kriegisch, Peter, 71229 Leonberg (DE); Hess, Peter, 71706 Markgröningen (DE); Bahagi, Arie, 71686 Remseck 5 (DE); Scheideler, Herbert, 71701 Schwieberdingen (DE)
(74) Vertreter: Brose, Gerhard, Dipl.-Ing.

(56) Entgegenhaltungen:
- DE-A- 4 013 886
- DE-A- 4 038 690
- US-A- 5 511 798

## Beschreibung

Die Erfindung betrifft ein Gehäuse mit EMV-geschirmter Kabeldurchführung der im Oberbegriff des Anspruchs 1 näher bezeichneten Ausführung. Gehäuse mit derartigen Kabeldurchführungen werden beispielsweise in der Nachrichtentechnik verwendet.

Bei einem aus der DE-A-40 38 690 bekannten Gehäuse mit EMV-geschirmter Kabeldurchführung sind innerhalb des Gehäuses an den Längsseiten einer-schlitzförmigen Öffnung auf einer Seite eine starr befestigte Trägerplatte und auf der anderen Seite eine durch Einhängen an der Trägerplatte und Einrasten an der Bodenplatte des Gehäuses lösbar befestigte Druckplatte angeordnet. Diese hat eine horizontal verlaufende, von außen nach innen eingedrückte Sicke und die Trägerplatte eine komplementäre, von innen nach außen durchgedrückte Sicke mit einem darin befestigten Kontaktschlauch. Die konvexen Biegekanten der Sicken bilden schienenartige Anlagepunkte, zwischen denen die Schirmgeflechte von durch die Öffnung geführten Kabeln mechanisch eingeklemmt und dabei elektrisch kontaktiert werden. Diese Kabeldurchführung gestattet das einlagige Durchführen von mehreren parallel nebeneinander angeordneten Kabeln.

Aus der EP-A-0 557 896 ist ferner eine Kabeldurchführung für EMV-geschirmte Schränke bekannt, die das Anordnen von Kabeln in mehreren Lagen gestattet. Die Kabeldurchführung besteht aus einer Baugruppe mit einem in der Deckenöffnung eines Schrankes fixierbaren, quaderförmigen Gehäuse, einem die Kabel lagenweise aufnehmenden Durchführungsteil, das an der Vorderseite zwischen vorgezogenen Seitenwänden des Gehäuses angebracht ist und einer zwischen die Seitenwönde bis an die Kabelabschirmung einschiebbaren Ansdruckvorrichtung.

Jede Kabellage ist für sich mit einer von mehreren, an den Seitenwänden des Durchführungsteiles nacheinander und treppenartig versetzt fixierbaren Druckplatte befestigt, die zugleich als Widerlager für die nächste Kabellage dient. Mit der in unterschiedlichen Raststellungen am Gehäuse befestigbaren Andruckvorrichtung werden die Schirmgeflechte der äußeren Lage Kabel elektrisch kontaktiert und zugleich eine in der Schrankdecke unausgefüllt bleibende Öffnung abgedeckt.

Die Baugruppe mit lagenweiser Durchführung von Kabeln ist jedoch konstruktiv relativ aufwendig und entsprechend teuer in der Herstellung. Außerdem erlaubt sie keine Durchführung von Kabelbündeln hoher Dichte.

Der Erfindung liegt die Aufgabe zugrunde, für EMV-geschirmte Gehäuse eine Kabeldurchführung zu schaffen, die einerseits ein individuelles Kontaktieren des Geflechtes geschirmter Kabel gestattet und andererseits auf einfache Weise an den unterschiedlichen Bedarf duchzuführender Kabelmengen angepaßt werden kann. Diese Aufgabe wird erfindungsgemäß von einer Kabeldurchführung. Mit den Merkmalen des Patentanspruchs 1 gelöst. Die Unteransprüche enthalten vorteilhafte Ausbildungen der Kabeldurchführung. Mit der Erfindung erzielbare Vorteile sind der Beschreibung zu entnehmen.

Die Erfindung wird anhand eines in Zeichnungen dargestellten Ausführungsbeispiels wie folgt näher beschrieben. In den Zeichnungen zeigen:
- Fig.1: den Ausschnitt eines Schrankgehäuses während der Montage einer Kabeldurchführung, in perspektivischer Ansicht;
- Fig. 2: den Ausschnitt eines Gehäuserahmens mit darin montierter Kabeldurchführung, in einer Seitenansicht;
- Fig. 3: eine Kontaktplatte der Kabeldurchführung von vorn gesehen und perspektivisch dargestellt;
- Fig. 4: die Rückseite der Kontaktplatte gemäß Fig. 3, als Ausschnitt dargestellt, in perspektivischer Ansicht;
- Fig. 5: eine schematische Darstellung der Kontaktplatte gemäß Fig. 3 mit hindurchgeführten Kabeln, in der Vorderansicht;
- Fig. 6: einen Ausschnitt von zwei aneinandergereihten Kontaktplatten gemäß Fig. 5, in der Draufsicht;
- Fig. 7: eine als Baugruppe ausgebildete Kabeldurchführung, in perspektivischer Ansicht.

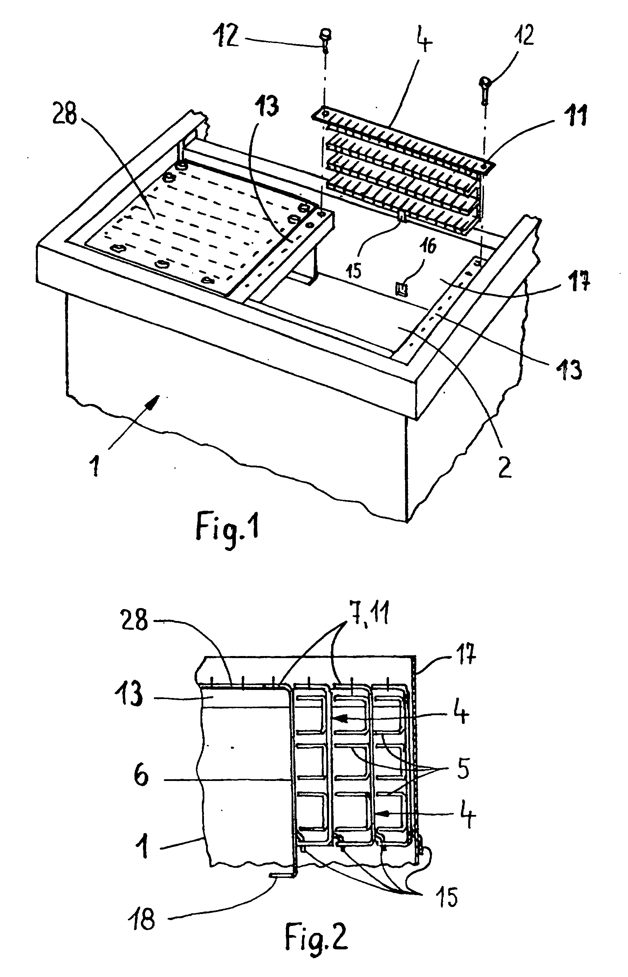

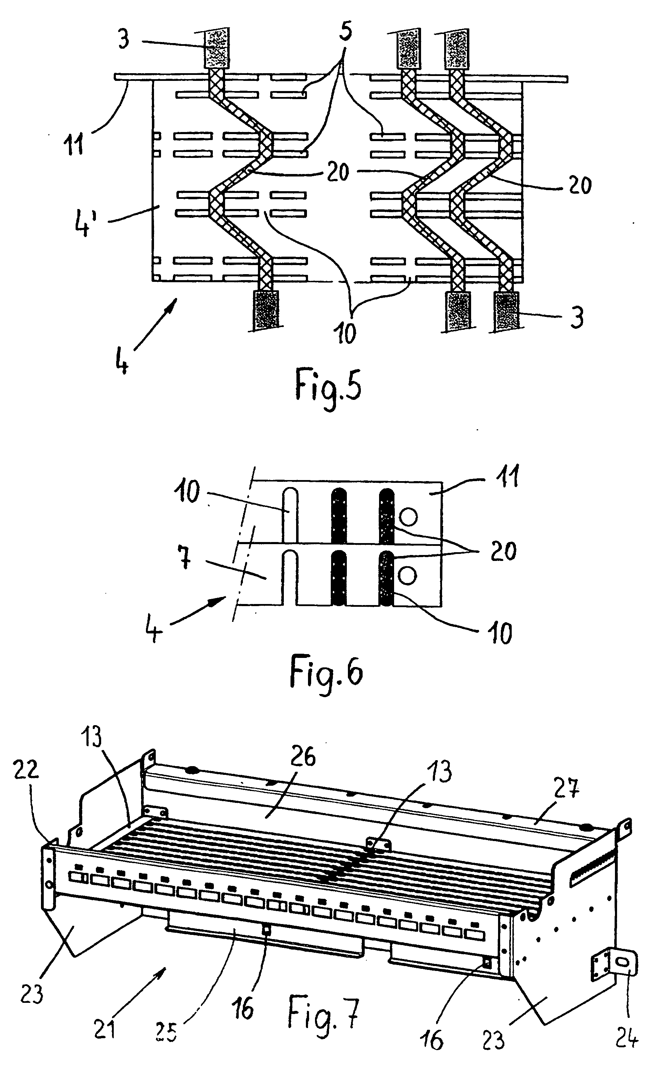

In Fig. 1 ist ein als Schrank konzipiertes Gehäuse mit 1 bezeichnet. Es hat beispielsweise in der Decke eine Öffnung 2 zur Durchführung von ankommenden und abgehenden Kabeln 3 (Fig. 5). Die hierbei verwendete Einrichtung, im folgenden Kabeldurchführung genannt, besteht im wesentlichen aus einer anreihbaren, elektrisch leitenden Kontaktplatte 4 mit einer größeren Anzahl von der Kontaktplatte 4 vorzugsweise rechtwinklig abstehenden Führungselementen 5 und einer die offene Seite der Kontaktplatte 4 an den freien Enden der Führungselemente 5 überdeckenden Abschlußplatte 6.

Wie insbesondere die Fig. 2 bis 4 zeigen, besteht die Kontaktplatte 4 im wesentlichen aus einer Grundplatte 4' in Form einer flachen Schiene U-förmigen Querschnitts mit wenigstens einer, bei dem dargestellten Ausführungsbeispiel jedoch mehreren zwischen beiden Schenkeln 7, 7' in parallelem Abstand zueinander angeordneten Profilschienen 8. Diese haben ebenfalls einen U-förmigen Querschnitt, jedoch stehen sich deren Schenkel 9 relativ nahe gegenüber. Die Schenkel 7, 7', 9 der Grundplatte 4 und der Profilschiene 8 sind gleich hoch und durch eine größere Anzahl Einschnitte in Kontaktzungen unterteilt. Die einen eckigen Querschnitt aufweisenden Kontaktzungen dienen den Kabeln 3 als Führungselemente 5 und die Einschnitte als Einlegeschlitze 10. Weil die Führungselemente 5 gleich lang sind, können mehrere Kontaktplatten 4 nahezu lückenlos aneinandergelegt und in dieser Lage befestigt werden. Dazu dienen Haltelaschen 11, die aus an beiden Seiten der Kontaktplatte 4 überstehenden Enden des oberen Schenkels 7 der Grundplatte 4' bestehen.

Die Kontaktplatten 4 werden vorzugsweise hängend montiert und zwar in der Weise, daß die Rückseite 14 der ersten Kontaktplatte 4 unmittelbar an die Gehäusewand 17 grenzt. Anschließend werden die Haltelaschen 11 mit Schrauben 12 an entsprechenden Tragschienen 13 und/oder Rahmenschenkeln des Gehäuses 1 befestigt und die maximal mögliche Anzahl Kabel 3 hindurchgeführt. Danach wird entweder eine weitere Kontaktplatte 4 oder die Abschlußplatte 6 montiert. Um einer aus mehreren Kontaktplatten 4 zusammengesetzten Kabeldurchführung eine größere mechanische Stabilität zu verleihen ist vorgesehen, daß bei wenigstens einer Kontaktzunge des unteren Schenkels 7' (Grundplatte 4') an der Kontaktplatten-Rückseite 14 ein Lappen 15 herausgekröpft ist, der bei der Montage einer ersten Kontaktplatte 4 vor dem Anschrauben der Haltelaschen 11 einen komplementären Ausschnitt 16 in der Gehäusewand 17 hintergreift. Der aus einer Kontaktzunge herausgekröpfte Lappen 15 hinterläßt einen Ausschnitt, in den bei Montage einer weiteren Kontaktplatte 4, dessen Lappen 15 eingreift und so fort, bis die Kabeldurchführung noch Bestückung der Einlegeschlitze 10 mit Kabeln 3 letztlich um die bereits erwähnte Abschlußplatte 6 vervollständigt wird. Sie ist ebenfalls mit der Befestigung dienenden Haltelaschen 11 versehen und hat dieselbe Anzahl an der Rückseite herausgekröpfte Lappen 15 wie die Kontaktplatte 4. Die Abschlußplatte 6 ist so breit und in der Vertikalen mindestens so lang wie die Kontaktplatte 4, jedoch hat sie am unteren Ende zweckmäßigerweise eine der Versteifung dienende Abkantung 18 (Fig. 2).

Die einzelnen Teile der Konkaktplatte 4 und die die Einlegeschlitze 10 letztlich verschließende Abschlußplatte 6 bestehen vorzugsweise aus nichtrostendem Stahlblech und lassen sich als Stanzbiegeteile äußerst kostengünstig herstellen. Hierfür können Stahlbänder passender Breite verwendet werden, die ein praktisch abfalloses Fertigen von Grundplatte 4', Abschlußplatte 6 und Profilschienen 8 gestatten. Letztere sind außerdem z.B. durch einfaches Punktschweißen in der flachen Schiene (Grundplatte 4') befestigbar.

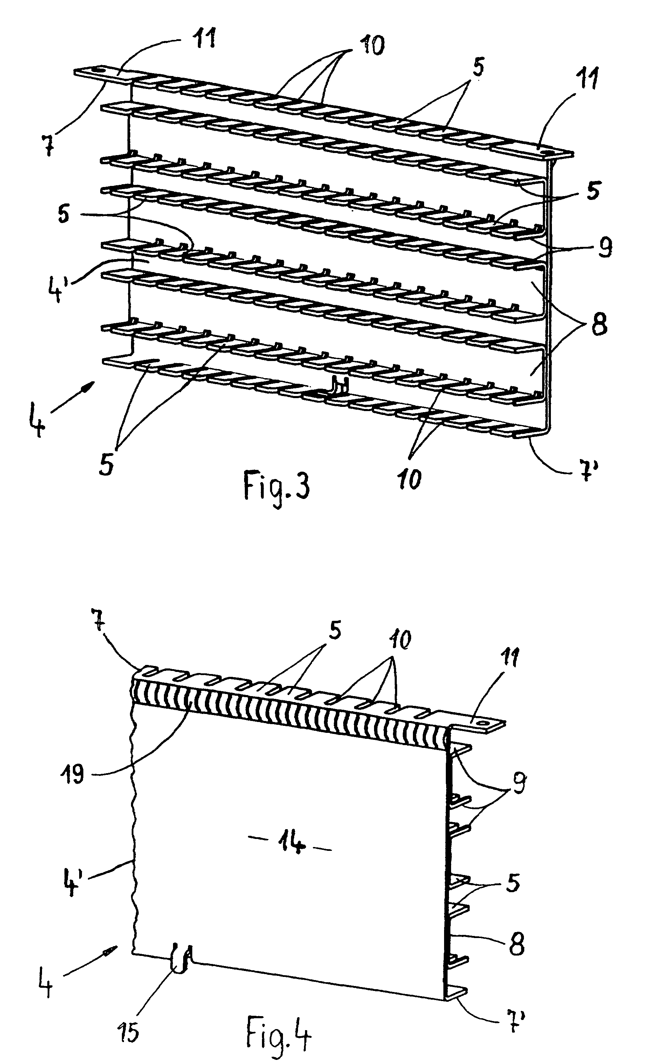

Obwohl Kontaktplatte 4 und Abschlußplatte 6 nahezu lückenlos aneinandergereiht montiert werden, hat es sich als zweckmäßig herausgestellt, jeweils am oberen Ende der Rückseite 14 eine elektromagnetisch wirkende Dichtung 19 vorzusehen. Diese kann beispielsweise aus einem elektrisch leitenden Moosgummistreifen, einem Monelgewebeband oder wie in Fig. 3 dargestellt, aus einem Kontaktfederstreifen bestehen. Nach erfolgter Montage der Kontaktplatte 4 bewirkt diese Maßnahme, daß die Enden z.B. der beiden oberen Reihen Führungselemente 5 gegen die Dichtung 19 angedrückt sind und dabei eine elektrisch einwandfrei leitende Verbindung herstellen.

Die Grundkonzeption der Kabeldurchführung erlaubt ohne weiteres eine Anpassung an verschiedene Anforderungen und die Kontaktplatte 4 entsprechend auszuführen. Bei dem in den Fig. 5 und 6 dargestellten Ausführungsbeispiel sind auf der Grundplatte 4' drei Profilschienen so fixiert, daß die Kontaktzungen benachbarter Schienenschenkel mehrere Reihen von elektrischen Doppelkontakten bilden. Außerdem sind in vertikaler Einbaulage der Kontaktplatte 4 die Kontaktzungen und Einlegeschlitze 10 sämtlicher Reihen untereinander, d.h. vertikal fluchtend angeordnet. Dies gestattet es, die auf einer vorbestimmten Länge vom äußeren Kabelmantel befreiten Kabel 3 mit dem freigelegten Schirmgeflecht 20 so durch die Einlegeschlitze 10 und um die Längskanten der Kontaktzungen herum zu führen, daß sie die Kontaktplatte 4 in Schlangenlinie durchlaufen, wobei jede in das Schirmgeflecht 20 drückende Längskante der Führungselemente 5 das Schirmgeflecht 20 elektrisch kontaktiert, mechanisch jedoch nicht beschädigt. Sofern die Einlegeschlitze 10 ausreichend breit dimensioniert sind, lassen sich Kabeltypen mit größerem und kleinerem, also mit voneinander abweichendem Durchmesser durch die Kontaktplatte 4 führen.

Bei einer bevorzugten Variante ist die Schlitzbreite jedoch nur geringfügig größer als der Schirmgeflecht-Durchmesser des häufig verwendeten Kabeltyps. Auch bei auftretenden Vibrationen wird hiermit eine sichere mechanische Halterung der Kabel 3 und zugleich eine gute elektrische Verbindung mit dem Schirmgeflecht 20 erzielt. Bei dem in den Fig. 5 und 6 dargestellten Ausführungsbeispiel können pro Durchführung nacheinander beispielsweise vier Kabel entweder lotrecht, oder, um eine optimale Funktionssicherheit der Kabeldurchführung zu gewährleisten, ebenfalls schlangenlinienförmig zwischen die Führungselemente 5 eingedrückt werden (Fig. 5 und 6).

Es versteht sich, daß die Teilungsabstände der Einlegeschlitze 10 innerhalb einer horizontalen Doppelreihe als auch der Abstand zur nächsten Doppelreihe Führungselementen 5 Einfluß auf den Biegeradius der Kabel 3 haben und entsprechend aufeinander abgestimmt sind. Daher werden zur Durchführung von Kabeln mit relativ großem Durchmesser, die keine kleinen Biegeradien vertragen, beispielsweise längere Kontaktplatten 4 mit breiteren Profilschienen 8 verwendet und/oder Kontaktplatten, bei denen die Führungselemente 5 so zueinander versetzt angeordnet sind, daß in der Vertikalen einer Doppelreihe Einlegeschlitze 10 jeweils eine Doppelreihe Führungselemente 5 folgt. Der Abstand zwischen den Führungselementen 5 einer Doppelreihe und der Abstand zu den Führungselementen 5 der nächsten Doppelreihe ist so gewählt, daß die kleinsten noch zulässigen Biegeradien nicht unterschritten werden. Ist dafür gesorgt, daß bei den in der Vertikalen längeren Kontaktplatten der herausgekröpfte Lappen 15 und entsprechende Ausschnitte 16 sich an der gleichen Stelle befinden wie bei kürzeren Kontaktplatten, kann ohne weiteres eine gemischte Montage beider Ausführungen vorgenommen werden.

Bei der in Fig. 7 dargestellten Einrichtung ist die Kabeldurchführung als Baugruppe 21 konzipiert. Sie weist einen mechanisch stabilen Rahmen 22 auf, der im wesentlichen aus zwei mit Befestigungslaschen 24 versehenen Seitenwänden 23, einem Vorderteil 25 und einer Rückwand 26 mit Querträger 27 zusammengesetzt ist und die eingangs bereits erwähnten Tragschienen 13 zur Befestigung der Kontaktplatten 4 enthält. Die Baugruppe 21 wird zur Montage in die Deckenöffnung des Schrankes eingesetzt und darin an Holmen und Kopfrahmen befestigt.

Die Baugruppe 21 hat, wie auch das in Fig. 1 dargestellte Gehäuse 1, z.B. zwei Kabeldurchführungsfelder, die bei Minderausbau mit Schlitzlochplatten 28 (Fig. 1) abgedeckt werden. Schlitze und Löcher sind in Reihen angeordnet, die dem Teilungsabstand der aneinanderreihbaren Kontaktplatten 4 entsprechen. In Abständen zwischen den Schlitzlochkombinationen vorgesehene Stege dienen als Sollbruchstellen, so daß die Schlitzlochplatte 28 je nach Füllungsgrad der Kabeldurchführung durch bedarfsweises Abtrennen immer wieder gekürzt werden kann. Bei Vollausbau können in eine Gehäuseöffnung von etwa 300 cm² beispielsweise 16 Kontaktplatten 4 eingesetzt und mehr als 1000 Mikrokoaxialkabel mit einem Kabelschirmdurchmesser von etwa 2,5 mm hindurchgeführt werden.

## Patentansprüche

1. Gehäuse (1) mit EMV-geschirmter Kabeldurchführung, bei dem von außerhalb in das Gehäuse (1) einmündende und aus dem Gehäuse (1) heraus abgehende, geschirmte Kabel (3) durch eine in einer Öffnung (2) des Gehäuses (1) angeordnete Kabeldurchführung laufen,
**dadurch gekennzeichnet,**
**daß** in die Öffnung (2) anreihbar ausgebildete, elektrisch leitende Kontaktplatten (4) eingesetzt sind, die jeweils mehrere von der Kontaktplatte (4) abstehende und elektrisch leitende Führungselemente (5) aufweisen, welche die Schirmgeflechte (20) der zwischen die Führungselemente (5) eingelegten Kabel (3) kontaktieren.

2. Kabeldurchführung nach Anspruch 1, **dadurch gekennzeichnet, daß** die Kontaktplatte (4) die Gestalt einer flachen Profilschiene U-förmigen Querschnitts hat, zwischen deren Schenkeln (7, 7') wenigstens eine weitere Profilschiene mit U-förmigem Querschnitt angeordnet ist.

3. Kabeldurchführung nach Anspruch 1 oder 2, **dadurch gekennzeichnet, daß** die Führungselemente (5) der Kontaktplatte (4) aus Einschnitte aufweisenden Schenkeln (7, 7', 9) der Profilschienen (z.B. 8) bestehen.

4. Kabeldurchführung nach einem der Ansprüche 1 bis 3, **dadurch gekennzeichnet, daß** die Führungselemente (5) als Kontaktzungen und die Einschnitte in den Schenkeln (7, 7', 9) der Profilschienen als Einlegeschlitze (10) für die Kabel (3) ausgebildet sind.

5. Kabeldurchführung nach einem der Ansprüche 1 bis 4, **dadurch gekennzeichnet, daß** die Kontaktzungen benachbarter Schienenschenkel (z.B. 7, 9) mehrere Reihen von elektrischen Doppelkontakten bilden.

6. Kabeldurchführung nach einem der Ansprüche 1 bis 5, **dadurch gekennzeichnet, daß** die Einlegeschlitze (10) zwischen horizontal benachbarten Doppelkontakten (Führungselemente 5) sämtlicher Reihen vertikal fluchten oder so alternierend angeordnet sind, daß unterhalb einer Doppelreihe Einlegeschlitze (10) sich jeweils eine Reihe Doppelkontakte befindet.

7. Kabeldurchführung nach einem der Ansprüche 1 bis 6, **dadurch gekennzeichnet, daß** die Kabel (3) schlangenlinienförmig um die Führungselemente (5) herum durch die Einlegeschlitze (10) der Kontaktplatte (4) laufen.

8. Kabeldurchführung nach einem der Ansprüche 1 bis 7, **dadurch gekennzeichnet, daß** bei wenigstens einer Kontaktzunge des unteren Schenkels (7') der- Kontaktplatte (4) an der Rückseite ein Lappen (15) für den Eingriff in einen entsprechenden Ausschnitt (z.B. 16) der Gehäusewand (17) oder einer anderen Kontaktplatte (4) herausgekröpft ist.

9. Kabeldurchführung nach einem der Ansprüche 1 bis 8, **dadurch gekennzeichnet, daß** die offene Seite der Kontaktplatte (4) bedarfsweise mit einer die Einlegeschlitze (10) verschließenden Abschlußplatte (6) abgedeckt ist.

10. Kabeldurchführung nach einem der Ansprüche 1 bis 9, **dadurch gekennzeichnet, daß** Kontaktplatte (4) und Abschlußplatte (6) jeweils am oberen Ende der Rückseite (z.B. 14) mit einer elektromagnetisch wirkenden Dichtung (19) versehen ist.

11. Kabeldurchführung nach einem der Ansprüche 1 bis 10, **dadurch gekennzeichnet, daß** sie als Baugruppe (21) ausgebildet ist, bei der die Kontaktplatten (4) innerhalb eines in die Gehäuseöffnung (2) einsetzbaren Rahmens (22) an Tragschienen der Baugruppe (21) befestigt sind.

12. Kabeldurchführung nach einem der Ansprüche 1 bis 11, **dadurch gekennzeichnet, daß** bei Minderausbau ein von den Kontaktplatten (4) nicht ausgefüllter Teil der Öffnung (z.B. 2) des Gehäuses (1) oder der Baugruppe (21) mit mindestens einer Schlitzlochplatte (28) abgedeckt ist.

## Claims

1. Housing (1) having an EMI-screened cable feedthrough, in which housing screened cables (3) opening into the housing (1) from the outside and those leaving the housing (1) pass through a cable feedthrough disposed in an opening (2) of the housing (1), **characterized in that** there can be inserted into the opening (2) contact plates (4) that are designed to be attached in series and are electrically conducting and that each have a plurality of electrically conducting guide elements (5) that project from the contact plate (4) and that contact the screening braiding (20) of the cables (3) inserted between the guide elements (5).

2. Cable feedthrough according to Claim 1, **characterized in that** the contact plate (4) has the form of a shallow profiled rail of U-shaped cross section between whose limbs (7, 7') at least one further profiled rail having U-shaped cross section is disposed.

3. Cable feedthrough according to Claim 1 or 2, **characterized in that** the guide elements (5) of the contact plate (4) comprise limbs (7, 7', 9) of the profiled rails (for example 8) having incisions.

4. Cable feedthrough according to any one of Claims 1 to 3, **characterized in that** the guide elements (5) are constructed as contact tongues and the incisions in the limbs (7, 7', 9) of the profiled rails are constructed as insertion slots (10) for the cables (3).

5. Cable feedthrough according to any one of Claims 1 to 4, **characterized in that** the contact tongues of adjacent rail limbs (for example, 7, 9) form a plurality of rows of electrical double contacts.

6. Cable feedthrough according to any one of Claims 1 to 5, **characterized in that** the insertion slots (10) between horizontally adjacent double contacts (guide elements 5) of all the rows are vertically in line or are disposed in an alternating manner in such a way that in each case a row of double contacts is located underneath a double row of insertion slots (10).

7. Cable feedthrough according to any one of Claims 1 to 6, **characterized in that** the cables (3) run in a snake-line fashion around the guide elements (5) through the insertion slots (10) of the contact plate (4).

8. Cable feedthrough according to any one of Claims 1 to 7, **characterized in that**, in the case of at least one of the contact tongues of the lower limb (7') of the contact plate (4), a tab (15) is crimped out at the back for engagement in a corresponding cutout (for example, 16) of the housing wall (17) or another contact plate (4).

9. Cable feedthrough according to any one of Claims 1 to 8, **characterized in that** the open side of the contact plate (4) is covered if necessary by means of a closing plate (6) that seals the insertion slots (10).

10. Cable feedthrough according to any one of Claims 1 to 9, **characterized in that** contact plate (4) and closing plate (6) are each provided at the upper end of the back (for example, 14) with a seal (19) having electromagnetic action.

11. Cable feedthrough according to any one of Claims 1 to 10, **characterized in that** it is constructed as an assembly (21) in which the contact plates (4) are mounted on support rails of the assembly (21) inside a frame (22) that can be inserted into the housing opening (2).

12. Cable feedthrough according to any one of Claims 1 to 11, **characterized in that**, in the minimum version, an opening (for example, 2) of the housing (1) or the assembly (21) that is not filled by the contact plates (4) is covered by at least one slot-and-hole plate (28).

## Revendications

1. Boîtier (1) avec passage de câble à blindage CEM, dans lequel des câbles blindés (3) débouchant sur le boîtier (1) à partir de l'extérieur et sortant du boîtier (1) s'étendent à travers un passage de câble disposé dans une ouverture (2) du boîtier (1), **caractérisé en ce que** des plaques porte-contacts (4) électroconductrices, réalisées pour un montage en série, sont insérées dans l'ouverture (2), les plaques présentant respectivement plusieurs éléments de guidage (5) électroconducteurs faisant saillie à partir de la plaque porte-contacts (4), les éléments mettant en contact les tresses de blindage (20) des câbles (3) insérés entre les éléments de guidage (5).

2. Passage de câble selon la revendication 1, **caractérisé en ce que** la plaque porte-contacts (4) présente la forme d'un simple rail profilé de section en forme de U, entre les branches (7, 7') duquel est disposé au moins un autre rail profilé de section en forme de U.

3. Passage de câble selon la revendication 1 ou 2, **caractérisé en ce que** les éléments de guidage (5) de la plaque porte-contacts (4) se composent de branches (7, 7', 9), présentant des encoches, des rails profilés (par exemple 8).

4. Passage de câble selon l'une quelconque des revendications 1 à 3, **caractérisé en ce que** les éléments de guidage (5) sont réalisés comme des lames de contact et les encoches dans les branches (7, 7', 9) des rails profilés sont réalisées comme des fentes d'insertion (10) pour les câbles (3).

5. Passage de câble selon l'une quelconque des revendications 1 à 4, **caractérisé en ce que** les lames de contact de branches de rail adjacentes (par exemple 7, 9) forment plusieurs rangées de contacts électriques jumelés.

6. Passage de câble selon l'une quelconque des revendications 1 à 5, **caractérisé en ce que** les fentes d'insertion (10) affleurent verticalement entre les contacts jumelés (éléments de guidage 5) horizontalement adjacents de toutes les rangées ou sont disposées en alternance de telle sorte qu'au-dessous d'une rangée double de fentes d'insertion (10) se trouve respectivement une rangée de contacts jumelés.

7. Passage de câble selon l'une quelconque des revendications 1 à 6, **caractérisé en ce que** les câbles s'étendent en zigzag autour des éléments de guidage (5) à travers les fentes d'insertion (10) de la plaque porte-contacts (4).

8. Passage de câble selon l'une quelconque des revendications 1 à 7, **caractérisé en ce que** pour au moins une lame de contact de la branche inférieure (7') de la plaque porte-contacts (4), un rabat (15) est coudé sur la face arrière pour venir en prise dans une entaille correspondante (par exemple 16) de la paroi de boîtier (17) ou d'une autre plaque porte-contacts (4).

9. Passage de câble selon l'une quelconque des revendications 1 à 8, **caractérisé en ce que** le côté ouvert de la plaque porte-contacts (4) est recouvert au besoin par une plaque d'obturation (6) fermant les fentes d'insertion (10).

10. Passage de câble selon l'une quelconque des revendications 1 à 9, **caractérisé en ce que** la plaque porte-contacts (4) et la plaque d'obturation (6) sont respectivement munies d'un joint (19) à effet électromagnétique à l'extrémité supérieure de la face arrière (par exemple 14).

11. Passage de câble selon l'une quelconque des revendications 1 à 10, **caractérisé en ce qu'**il est réalisé comme un sous-ensemble (21) dans lequel les plaques porte-contacts (4) sont fixées sur des rails de support du sous-ensemble (21) à l'intérieur d'un cadre (22) insérable dans l'ouverture de boîtier (2).

12. Passage de câble selon l'une quelconque des revendications 1 à 11, **caractérisé en ce qu'**en cas de démontage minimal, une partie de l'ouverture (par exemple 2) du boîtier (1) ou du sous-ensemble (21) non remplie par les plaques porte-contacts (4) est recouverte par au moins une plaques à lumières oblongues (28).
